# EUROPEAN PATENT APPLICATION

(11) **EP 4 734 130 A1**
(43) Date of publication of application: **29.04.2026**
(21) Application number: 24825838.6
(22) Date of filing: 14.06.2024
(51) Int. Cl.: H01B 13/00, H01B 12/10

(54) **NB3SN SUPERCONDUCTING WIRE PRECURSOR, AND NB3SN SUPERCONDUCTING WIRE**

(30) Priority: 22.06.2023 JP 2023102175
(71) Applicant: FURUKAWA ELECTRIC CO., LTD., Chiyoda-ku, Tokyo 100-8322 (JP)
(72) Inventor: TANIGUCHI Ryo, Tokyo 100-8322 (JP); SUGIMOTO Masahiro, Tokyo 100-8322 (JP); HIROSE Kiyoshige, Tokyo 100-8322 (JP)
(74) Representative: Winter, Brandl - Partnerschaft mbB
(86) International application number: PCT/JP2024/021702
(87) International publication number: WO 2024/262435

(57) **Abstract**

A Nb₃Sn superconducting wire precursor includes a tubular stabilizing copper layer provided on an outer periphery, a tubular first Sn diffusion barrier layer provided inside the stabilizing copper layer, and
a superconducting element group precursor housed inside the first Sn diffusion barrier layer. The superconducting element group precursor includes a plurality of Sn-based element wires and a plurality of Nb-based superconducting element wire precursors. The plurality of Sn-based element wires each include a first stabilizing matrix including Cu or a Cu-based alloy, and one or more Sn-based filaments embedded in the first stabilizing matrix and including Sn or a Sn-based alloy. The plurality of Nb-based superconducting element wire precursors each include a second stabilizing matrix including Cu or a Cu-based alloy, and a plurality of Nb-based reinforcing filaments including Nb or a Nb-based alloy and a plurality of Nb-based superconducting filament precursors having a diameter larger than that of the Nb-based reinforcing filaments, both of which are embedded in the second stabilizing matrix, and/or the plurality of Nb-based superconducting element wire precursors include a plurality of Nb-based reinforcing sub-elements each including a third stabilizing matrix including Cu or a Cu-based alloy, and a plurality of Nb-based reinforcing filaments embedded in the third stabilizing matrix and including Nb or a Nb-based alloy, and a plurality of Nb-based superconducting sub-element precursors each including a fourth stabilizing matrix including Cu or a Cu-based alloy, and a plurality of Nb-based superconducting filament precursors embedded in the fourth stabilizing matrix and including Nb or a Nb-based alloy and having a diameter larger than that of the Nb-based reinforcing filaments.

## Description

### TECHNICAL FIELD

The present disclosure relates to a Nb₃Sn superconducting wire precursor and a Nb₃Sn superconducting wire.

### BACKGROUND ART

As a conventionally widely used method for producing a Nb₃Sn superconducting wire, there is a bronze method in which a wire having a structure with a plurality of Nb filaments embedded in a Cu-Sn-based alloy (bronze) matrix is heat-treated to produce Nb₃Sn being a superconducting phase due to diffusion of Sn in the bronze matrix into the Nb filaments.

However, in the bronze method, since there is an upper limit (solid solubility limit) to the concentration of Sn that can be dissolved in bronze, there is a limit to the area of Nb₃Sn that can be produced, and as a result, there is a limit to the improvement of the critical current density Jc of the superconducting wire.

As a method for producing a Nb₃Sn superconducting wire, there is a method called an internal diffusion method in addition to the bronze method. In the internal diffusion method, a wire having a structure in which Nb-based alloy filaments and Sn-based alloy filaments are embedded in a Cu-based alloy matrix is heat-treated to diffuse Sn in the Sn-based alloy filaments into the Nb-based alloy filaments, thereby generating Nb₃Sn at the interface between the Nb-based alloy filaments and the Cu-based alloy matrix.

In the internal diffusion method, since the solid solubility limit of Sn in a Cu-Sn-based alloy, which becomes a problem in the bronze method, does not have an effect, the generation area of Nb₃Sn can be improved, and hence a high critical current density Jc can be obtained. In addition, in the internal diffusion method, since the Sn concentration can be increased as compared with the bronze method, high-quality Nb₃Sn can be generated.

It is known that the critical current density Jc of Nb₃Sn is sensitively affected by mechanical strain of Nb₃Sn regardless of its production method. In particular, when Nb₃Sn is used in a high magnetic field magnet, the critical current density Jc decreases due to strain caused by electromagnetic force, and therefore, improvement in mechanical strength is required.

As methods for improving the strength of a Nb₃Sn superconducting wire produced by the internal diffusion method, a method of disposing a reinforcing metal core in a Nb element wire (for example, see Patent Document 1), and a method of replacing parts of element wires with reinforcing element wires (for example, see Patent Document 2) have been proposed.

However, in the method of providing a reinforcing metal core in a Nb element wire as disclosed in Patent Document 1, deterioration in wire drawing workability due to a difference in mechanical properties between the Nb element wire and the reinforcing metal core, and deterioration in the shape of the superconducting filament accompanying the deterioration cannot be ignored.

Also, in the method of replacing parts of the element wires with the reinforcing element wires as disclosed in Patent Document 2, deterioration in workability due to dispersively arrangement of the reinforcing element wires with poor workability in the superconducting filament, and complication of the producing process due to the addition of the reinforcing element wire to the element wire cannot be ignored.

Further, in recent years, development of experimental reactors for realizing high-performance large accelerators and nuclear fusion reactors has been advanced, and there is a need for superconducting wires that have a high critical current density Jc and good manufacturability during a stranding process. However, as described above, conventional art does not sufficiently satisfy these needs.

### Citation List

### Patent Documents

Patent Document 1: Japanese Unexamined Patent Application, Publication No. 2017-142898
Patent Document 2: Japanese Unexamined Patent Application, Publication No. 2010-135215

### DISCLOSURE OF THE INVENTION

### Problems to be Solved by the Invention

An object of the present disclosure is to provide a Nb₃Sn superconducting wire precursor for producing a superconducting wire having high mechanical strength and a Nb₃Sn superconducting wire capable of suppressing a decrease in critical current density Jc due to tensile stress in an axial direction and compressive stress in a radial direction, and suppressing damage to superconducting filament precursors due to a stranding or rolling process.

### Means for Solving the Problems

[1] A Nb₃Sn superconducting wire precursor including: a tubular stabilizing copper layer provided on an outer periphery; a tubular first Sn diffusion barrier layer provided inside the stabilizing copper layer; and a superconducting element group precursor housed inside the first Sn diffusion barrier layer, the superconducting element group precursor including a plurality of Sn-based element wires and a plurality of Nb-based superconducting element wire precursors, the plurality of Sn-based element wires including a first stabilizing matrix containing Cu or a Cu-based alloy, and one or more Sn-based filaments embedded in the first stabilizing matrix and containing Sn or a Sn-based alloy, the plurality of Nb-based superconducting element wire precursors including a second stabilizing matrix containing Cu or a Cu-based alloy, a plurality of Nb-based reinforcing filaments embedded in the second stabilizing matrix and including Nb or a Nb-based alloy, and a plurality of Nb-based superconducting filament precursors having a diameter larger than that of the Nb-based reinforcing filaments, embedded in the second stabilizing matrix, and including Nb or a Nb-based alloy, and/or a plurality of Nb-based reinforcing sub-elements including a third stabilizing matrix containing Cu or a Cu-based alloy, and a plurality of Nb-based reinforcing filaments embedded in the third stabilizing matrix and containing Nb or a Nb-based alloy; and a plurality of Nb-based superconducting sub-element precursors including a fourth stabilizing matrix containing Cu or a Cu-based alloy, and a plurality of Nb-based superconducting filament precursors embedded in the fourth stabilizing matrix, containing Nb or a Nb-based alloy, and having a diameter larger than that of the Nb-based reinforcing filaments.
[2] In the Nb₃Sn superconducting wire precursor according to [1] above, in a cross section perpendicular to an axial direction of the Nb₃Sn superconducting wire precursor, in each of the plurality of Nb-based superconducting element wire precursors, a Nb-based reinforcing filament aggregate in which the plurality of Nb-based reinforcing filaments are aggregated is disposed in a center, and a Nb-based superconducting filament aggregate precursor in which the plurality of Nb-based superconducting filament precursors are aggregated is disposed on an outer periphery.
[3] In the Nb₃Sn superconducting wire precursor according to [2] above, the Nb-based superconducting element wire precursors further include a second Sn diffusion barrier layer provided between the Nb-based reinforcing filament aggregate and the Nb-based superconducting filament aggregate precursor in the cross section perpendicular to the axial direction of the Nb₃Sn superconducting wire precursor, the second Sn diffusion barrier layer containing a pure metal or alloy each containing Ta or Nb.
[4] In the Nb₃Sn superconducting wire precursor according to [1] above, in a cross section perpendicular to an axial direction of the Nb₃Sn superconducting wire precursor, the plurality of Nb-based superconducting sub-element precursors and the plurality of Sn-based element wires are disposed in a center of the superconducting element group precursor, and the plurality of Nb-based reinforcing sub-elements are disposed on an outer periphery of the superconducting element group precursor.
[5] In the Nb₃Sn superconducting wire precursor according to any one of [1] to [4] above, the first Sn diffusion barrier layer includes a pure metal or alloy each containing Ta or Nb.
[6] A Nb₃Sn superconducting wire including a tubular stabilizing copper layer provided on an outer periphery; a tubular first Sn diffusion barrier layer provided inside the stabilizing copper layer; and a superconducting element group housed inside the first Sn diffusion barrier layer, the superconducting element group including a plurality of Nb-based superconducting element wires, the plurality of Nb-based superconducting element wires including a second stabilizing matrix containing Cu or a Cu-based alloy and a plurality of superconducting filaments embedded in the second stabilizing matrix, the plurality of superconducting filaments including a plurality of Nb-based reinforcing filaments containing Nb or a Nb-based alloy and a compound superconducting phase containing Nb₃Sn, and the plurality of superconducting filaments having a diameter larger than that of the Nb-based reinforcing filaments, and/or a plurality of Nb-based reinforcing sub-elements including a third stabilizing matrix containing Cu or a Cu-based alloy, and a plurality of Nb-based reinforcing filaments embedded in the third stabilizing matrix and containing Nb or a Nb-based alloy; and a plurality of superconducting sub-elements including a fourth stabilizing matrix containing Cu or a Cu-based alloy, and a plurality of superconducting filaments embedded in the fourth stabilizing matrix, the plurality of superconducting filaments including a compound superconducting phase containing Nb₃SN, and the plurality of superconducting filaments having a diameter larger than that of the Nb-based reinforcing filaments.
[7] In the Nb₃Sn superconducting wire according to [6] above, the first Sn diffusion barrier layer includes a pure metal or alloy each containing Ta or Nb.

### Effects of the Invention

According to the present disclosure, it is possible to provide a Nb₃Sn superconducting wire precursor for producing a superconducting wire having high mechanical strength and a Nb₃Sn superconducting wire capable of suppressing a decrease in critical current density Jc due to tensile stress in an axial direction and compressive stress in a radial direction, and suppressing damage to superconducting filament precursors due to a stranding or rolling process.

### BRIEF DESCRIPTION OF THE DRAWINGS

FIG. 1 is a transverse cross-sectional view showing an example of a Nb₃Sn superconducting wire precursor according to a first embodiment.
FIG. 2 is a transverse cross-sectional view showing another example of a Nb-based superconducting element wire precursor constituting the Nb₃Sn superconducting wire precursor according to the first embodiment.
FIG. 3 is a transverse cross-sectional view showing a Nb₃Sn superconducting wire obtained by heating the Nb₃Sn superconducting wire precursor of FIG. 1.
FIG. 4 is a transverse cross-sectional view showing an Nb-based superconducting element wire obtained by heating the Nb-based superconducting element wire precursor of FIG. 2.
FIG. 5 is a transverse cross-sectional view showing an example of a Nb₃Sn superconducting wire precursor according to a second embodiment.
FIG. 6 is a transverse cross-sectional view showing a Nb₃Sn superconducting wire obtained by heating the Nb₃Sn superconducting wire precursor of FIG. 5.

### PREFERRED MODE FOR CARRYING OUT THE INVENTION

Hereinafter, detailed descriptions will be given based on embodiments.

As a result of intensive studies, the present inventors have found that, in a Nb₃Sn superconducting wire precursor, a plurality of Nb-based superconducting element wire precursors, constituting a superconducting element group precursor housed inside a diffusion barrier layer, have a predetermined configuration, so that the Nb₃Sn superconducting wire obtained by heat-treating the Nb₃Sn superconducting wire precursor has high mechanical strength capable of suppressing a decrease in critical current density Jc due to tensile stress in an axial direction and compressive stress in a radial direction, and capable of suppressing damage to superconducting filament precursors due to a stranding or rolling process, and have completed the present disclosure based on such finding.

A Nb₃Sn superconducting wire precursor of an embodiment includes a tubular stabilizing copper layer provided on an outer periphery, a tubular first Sn diffusion barrier layer provided inside the stabilizing copper layer, and a superconducting element group precursor housed inside the first Sn diffusion barrier layer. The superconducting element group precursor includes a plurality of Sn-based element wires and a plurality of Nb-based superconducting element wire precursors. The plurality of Sn-based element wires includes a first stabilizing matrix containing Cu or a Cu-based alloy, and one or more Sn-based filaments embedded in the first stabilizing matrix and containing Sn or a Sn-based alloy. The plurality of Nb-based superconducting element wire precursors include a second stabilizing matrix containing Cu or a Cu-based alloy, a plurality of Nb-based reinforcing filaments embedded in the second stabilizing matrix and containing Nb or a Nb-based alloy, and a plurality of Nb-based superconducting filament precursors having a diameter larger than that of the Nb-based reinforcing filaments, embedded in the second stabilizing matrix, and including Nb or a Nb-based alloy, and/or a plurality of Nb-based reinforcing sub-elements including a third stabilizing matrix containing Cu or a Cu-based alloy, and a plurality of Nb-based reinforcing filaments embedded in the third stabilizing matrix and containing Nb or a Nb-based alloy; and a plurality of Nb-based superconducting sub-element precursors including a fourth stabilizing matrix containing Cu or a Cu-based alloy, and a plurality of Nb-based superconducting filament precursors embedded in the fourth stabilizing matrix, containing Nb or a Nb-based alloy, and having a diameter larger than that of the Nb-based reinforcing filaments.

A Nb₃Sn superconducting wire of the embodiment includes a tubular stabilizing copper layer provided on an outer periphery, a tubular first Sn diffusion barrier layer provided inside the stabilizing copper layer, and a superconducting element group housed inside the first Sn diffusion barrier layer. The superconducting element group includes a plurality of Nb-based superconducting element wires. The plurality of Nb-based superconducting element wires include a second stabilizing matrix containing Cu or a Cu-based alloy and a plurality of superconducting filaments embedded in the second stabilizing matrix, the plurality of superconducting filaments including a plurality of Nb-based reinforcing filaments containing Nb or a Nb-based alloy and a compound superconducting phase containing Nb₃Sn, and the plurality of superconducting filaments having a diameter larger than that of the Nb-based reinforcing filaments, and/or a plurality of Nb-based reinforcing sub-elements including a third stabilizing matrix containing Cu or a Cu-based alloy, and a plurality of Nb-based reinforcing filaments embedded in the third stabilizing matrix and containing Nb or a Nb-based alloy; and a plurality of superconducting sub-elements including a fourth stabilizing matrix containing Cu or a Cu-based alloy, and a plurality of superconducting filaments embedded in the fourth stabilizing matrix, the plurality of superconducting filaments including a compound superconducting phase containing Nb₃SN, and the plurality of superconducting filaments having a diameter larger than that of the Nb-based reinforcing filaments.

### (First Embodiment)

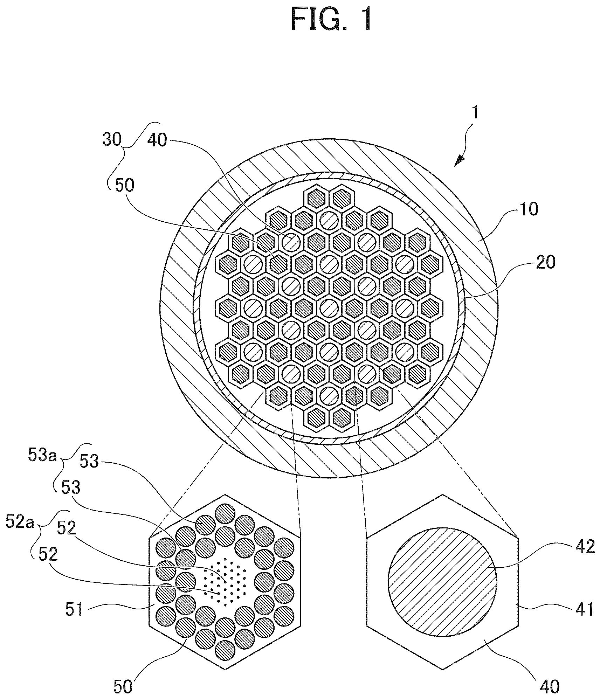

FIG. 1 is a transverse cross-sectional view showing an example of a Nb₃Sn superconducting wire precursor according to a first embodiment. The transverse cross-sectional view of a Nb₃Sn superconducting wire precursor 1 is a view of a cross section perpendicular to the axial direction (longitudinal direction) of the Nb₃Sn superconducting wire precursor 1. As shown in FIG. 1, the Nb₃Sn superconducting wire precursor 1 according to the first embodiment includes a tubular stabilizing copper layer 10, a tubular first Sn diffusion barrier layer 20, and a superconducting element group precursor 30.

The stabilizing copper layer 10 constituting the Nb₃Sn superconducting wire precursor 1 has a tubular shape, is provided on the outer periphery of the Nb₃Sn superconducting wire precursor 1, and covers the first Sn diffusion barrier layer 20 from the outside. The stabilizing copper layer 10 includes Cu or a Cu alloy.

The first Sn diffusion barrier layer 20 constituting the Nb₃Sn superconducting wire precursor 1 has a tubular shape and is provided inside the stabilizing copper layer 10. The first Sn diffusion barrier layer 20 preferably includes a pure metal containing Ta or Nb or an alloy containing Ta or Nb.

The first Sn diffusion barrier layer 20 suppresses bronzing of the stabilizing copper layer 10 due to diffusion of Sn in the Sn-based filaments 42 into the stabilizing copper layer 10 during a heat treatment for generating a compound superconducting phase 73 including Nb₃Sn described later to suppress a decrease in superconducting characteristics such as a residual resistance ratio, and holds an amount of Sn necessary for generating Nb₃Sn, inside the first Sn diffusion barrier layer 20, by reacting with Nb-based superconducting filament precursors 53.

The superconducting element group precursor 30 constituting the Nb₃Sn superconducting wire precursor 1 is housed inside the first Sn diffusion barrier layer 20. The superconducting element group precursor 30 includes a plurality of Sn-based element wires 40 and a plurality of Nb-based superconducting element wire precursors 50.

Each of the plurality of Sn-based element wires 40 includes a first stabilizing matrix 41 and one or more Sn-based filaments 42. The first stabilizing matrix 41 includes Cu or a Cu-based alloy. The Sn-based filament 42 includes Sn or an Sn-based alloy, and is embedded in the first stabilizing matrix 41. By applying a heat treatment for generating the compound superconducting phase 73 described later, the Sn in the Sn-based filament 42 reacts with the Nb-based superconducting filament precursors 53 in the Nb-based superconducting element wire precursors 50 to form the compound superconducting phases 73 including Nb₃Sn. In the Nb₃Sn superconducting wire 2 described later, when the Sn-based element wire 40 is heat-treated, Sn diffuses, and thus, the Sn-based filament 42 no longer exists as a filament, but is bronzed and becomes partially hollow.

FIG. 1 shows an example in which each of the plurality of Sn-based element wires 40 includes a single Sn-based filament 42, but each of the plurality of Sn-based element wires 40 may include a plurality of Sn-based filaments 42, or the plurality of Sn-based element wires 40 may be a combination of a Sn-based element wire 40 including a single Sn-based filament 42 and a Sn-based element wire 40 including a plurality of Sn-based filaments 42.

Each of the plurality of Nb-based superconducting element wire precursors 50 includes a second stabilizing matrix 51, a plurality of Nb-based reinforcing filaments 52, and a plurality of Nb-based superconducting filament precursors 53. The second stabilizing matrix 51 includes Cu or a Cu-based alloy. The plurality of Nb-based reinforcing filaments 52 and the plurality of Nb-based superconducting filament precursors 53 both include Nb or an Nb-based alloy, and are embedded in the second stabilizing matrix 51.

The diameter of the Nb-based superconducting filament precursor 53 is larger than the diameter of the Nb-based reinforcing filament 52. For example, the diameter of the Nb-based reinforcing filament 52 is 0.04 µm or more and 0.30 µm or less, and the diameter of the Nb-based superconducting filament precursor 53 is 1 µm or more and 10 µm or less.

In a cross section perpendicular to the axial direction of the Nb₃Sn superconducting wire precursor 1, the ratio of the total area of the plurality of Nb-based reinforcing filaments 52 to the area of a Nb-based reinforcing filament aggregate 52a in which the plurality of Nb-based reinforcing filaments 52 are aggregated is smaller than the ratio of the total area of the plurality of Nb-based superconducting filament precursors 53 to the area of a Nb-based superconducting filament aggregate precursor 53a in which the plurality of Nb-based superconducting filament precursors 53 are aggregated. For example, the ratio of the total area of the plurality of Nb-based reinforcing filaments 52 to the area of the Nb-based reinforcing filament aggregate 52a is 0.1 or more and 0.5 or less, and the ratio of the total area of the plurality of Nb-based superconducting filament precursors 53 to the area of the Nb-based superconducting filament aggregate precursor 53a is 0.6 or more and 0.9 or less. Here, it is defined that the Nb-based reinforcing filament aggregate 52a includes the plurality of Nb-based reinforcing filaments 52 and the second stabilizing matrix 51 existing between the plurality of Nb-based reinforcing filaments 52, and does not include the second stabilizing matrix 51 not interposed between the plurality of Nb-based reinforcing filaments 52. It is defined that the Nb-based superconducting filament aggregate precursor 53a includes the plurality of Nb-based superconducting filament precursors 53 and the second stabilizing matrix 51 existing between the plurality of Nb-based superconducting filament precursors 53, and does not include the second stabilizing matrix 51 not interposed between the plurality of Nb-based superconducting filament precursors 53.

By applying a heat treatment for generating the compound superconducting phase 73 described later, all or part of the Nb-based superconducting filament precursors 53 reacts with Sn diffused from the Sn-based filament 42 to form a filament-shaped compound superconducting phase 73 including Nb₃Sn.

As described above, by providing the plurality of Nb-based reinforcing filaments 52 in the Nb-based superconducting element wire precursor 50, the Nb₃Sn superconducting wire precursor 1 and the Nb₃Sn superconducting wire described later have high mechanical strength against tensile stress along the axial direction. Therefore, a decrease in the critical current density Jc of the Nb₃Sn superconducting wire due to the tensile stress in the axial direction can be suppressed. In addition, when compressive stress along the radial direction is applied to the Nb₃Sn superconducting wire precursor 1 or the Nb₃Sn superconducting wire, the second stabilizing matrix 51 of the portion in which the Nb-based reinforcing filaments 52 are embedded, in other words, the second stabilizing matrix 51 of the Nb-based reinforcing filament aggregate 52a is preferentially deformed. Therefore, damage to the superconducting filament during a stranding or rolling process is small, and a decrease in the critical current density Jc of the Nb₃Sn superconducting wire can be suppressed. As described above, since damage to the superconducting filament precursors due to a stranding process or a rolling process can be suppressed, the superconducting filaments are protected, and thus the Nb₃Sn superconducting wire can exhibit a high critical current density Jc even when subjected to a stranding process.

The Nb-based reinforcing filament 52 and the Nb-based superconducting filament precursor 53 are both Nb or an Nb-based alloy. Therefore, it is possible to avoid deterioration in workability due to adjacent members having different mechanical properties.

It is preferable that, as shown in FIG. 1, in the cross section perpendicular to the axial direction of the Nb₃Sn superconducting wire precursor 1, in each of the plurality of Nb-based superconducting element wire precursors 50, the Nb-based reinforcing filament aggregate 52a in which the plurality of Nb-based reinforcing filaments 52 are aggregated is disposed in the center, and the Nb-based superconducting filament aggregate precursor 53a in which the plurality of Nb-based superconducting filament precursors 53 are aggregated is disposed on the outer periphery. In this case, the annular Nb-based superconducting filament aggregate precursor 53a disposed over the entire outer periphery of the Nb-based superconducting element wire precursor 50 surrounds the Nb-based reinforcing filament aggregate 52a disposed in the center of the Nb-based superconducting element wire precursor 50. With such a configuration, Sn diffused from the Sn-based filaments 42 preferentially reacts with the plurality of Nb-based superconducting filament precursors 53 when the Nb₃Sn superconducting wire precursor 1 is subjected to a heat treatment for generating the compound superconducting phase 73 including Nb₃Sn described later, so that a high-quality compound superconducting phase 73 of Nb₃Sn is easily formed.

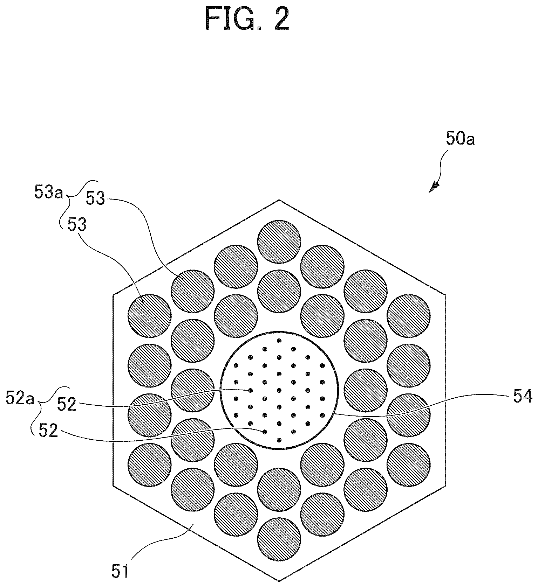

FIG. 2 is a transverse cross-sectional view showing another example of the Nb-based superconducting element wire precursor constituting the Nb₃Sn superconducting wire precursor of the first embodiment. It is preferable that, as shown in FIG. 2, the Nb-based superconducting element wire precursor 50a further includes a second Sn diffusion barrier layer 54 provided between the Nb-based reinforcing filament aggregate 52a and the Nb-based superconducting filament aggregate precursor 53a in the cross section perpendicular to the axial direction of the Nb₃Sn superconducting wire precursor 1, and the second Sn diffusion barrier layer 54 includes a pure metal containing Ta or Nb or an alloy containing Ta or Nb. In this case, the second Sn diffusion barrier layer 54 completely surrounds the Nb-based reinforcing filament aggregate 52a. The second Sn diffusion barrier layer 54 has a tubular shape, and has an annular shape in the cross section perpendicular to the axial direction of the Nb₃Sn superconducting wire precursor 1.

With the configuration shown in FIG. 2, Sn in the Sn-based filaments 42 is further prevented from diffusing into the Nb-based reinforcing filament aggregate 52a and reacting with the Nb-based reinforcing filaments 52 to form Nb₃Sn during the heat treatment for generating the compound superconducting phase 73 described later. That is, even when the heat treatment is applied, the reaction from the Nb-based reinforcing filament 52 to a compound superconducting phase including Nb₃Sn having a low tensile strength is suppressed. Therefore, it is possible to further suppress a decrease in the mechanical strength of the Nb₃Sn superconducting wire precursor 1 and the Nb₃Sn superconducting wire against the tensile stress in the axial direction.

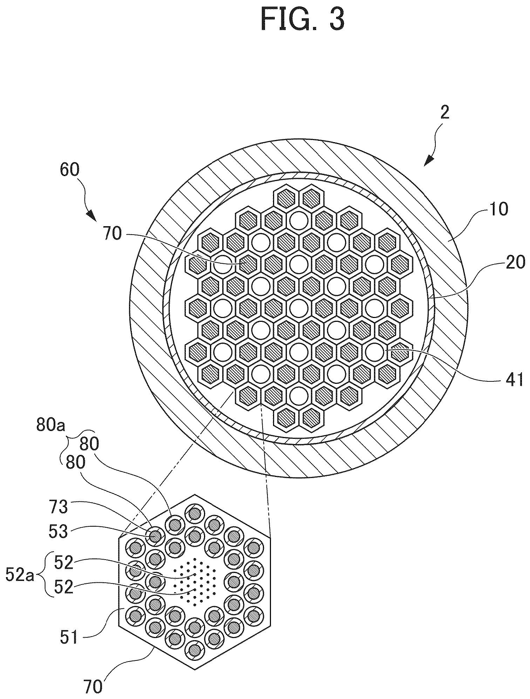

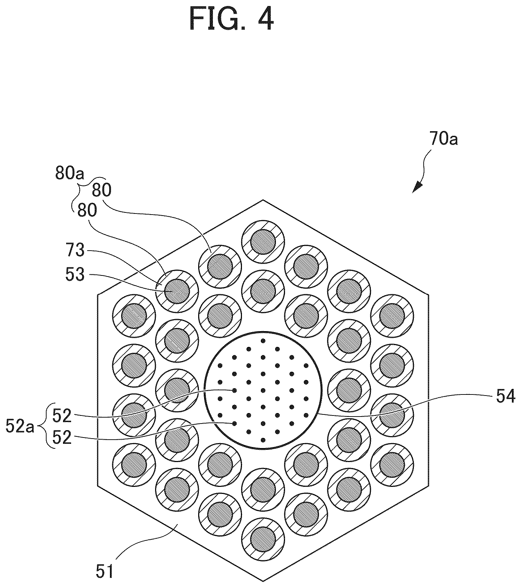

Next, the Nb₃Sn superconducting wire 2 obtained by subjecting the Nb₃Sn superconducting wire precursor 1 to a heat treatment for generating the compound superconducting phase 73 including Nb₃Sn will be described. FIG. 3 is a transverse cross-sectional view showing the Nb₃Sn superconducting wire 2 obtained by heating the Nb₃Sn superconducting wire precursor 1 of FIG. 1. FIG. 4 is a transverse cross-sectional view showing a Nb-based superconducting element wire 70a obtained by heating the Nb-based superconducting element wire precursor 50a of FIG. 2.

As shown in FIG. 3, the Nb₃Sn superconducting wire 2, which is a heat-treated product of the Nb₃Sn superconducting wire precursor 1, includes a tubular stabilizing copper layer 10, a tubular first Sn diffusion barrier layer 20, and a superconducting element group 60.

The stabilizing copper layer 10 and the first Sn diffusion barrier layer 20 of the Nb₃Sn superconducting wire 2 have the same configuration as the stabilizing copper layer 10 and the first Sn diffusion barrier layer 20 of the Nb₃Sn superconducting wire precursor 1.

The superconducting element group 60 is housed inside the first Sn diffusion barrier layer 20. As shown in FIGS. 3 and 4, the superconducting element group 60 includes a plurality of Nb-based superconducting element wires 70, 70a.

Each of the plurality of Nb-based superconducting element wires 70, 70a includes a second stabilizing matrix 51 including Cu or a Cu-based alloy, a plurality of Nb-based reinforcing filaments 52 including Nb or a Nb-based alloy, and a plurality of superconducting filaments 80. The plurality of Nb-based reinforcing filaments 52 and the plurality of superconducting filaments 80 are both embedded in the second stabilizing matrix 51.

Each of the plurality of superconducting filaments 80 includes a compound superconducting phase 73 including Nb₃Sn. The diameter of the superconducting filament 80 is larger than the diameter of the Nb-based reinforcing filament 52. For example, the diameter of the Nb-based reinforcing filament 52 is 0.04 µm or more and 0.30 µm or less, and the diameter of the superconducting filament 80 is 1 µm or more and 10 µm or less.

In a cross section perpendicular to the axial direction of the Nb₃Sn superconducting wire 2, the ratio of the total area of the plurality of Nb-based reinforcing filaments 52 to the area of the Nb-based reinforcing filament aggregate 52a in which the plurality of Nb-based reinforcing filaments 52 are aggregated is smaller than the ratio of the total area of the plurality of superconducting filaments 80 to the area of the superconducting filament aggregate 80a in which the plurality of superconducting filaments 80 are aggregated. For example, the ratio of the total area of the plurality of Nb-based reinforcing filaments 52 to the area of the Nb-based reinforcing filament aggregate 52a is 0.1 or more and 0.5 or less, and the ratio of the total area of the plurality of superconducting filaments 80 to the area of the superconducting filament aggregate 80a is 0.6 or more and 0.9 or less. Here, it is defined that the superconducting filament aggregate 80a includes the plurality of superconducting filaments 80 and the second stabilizing matrix 51 existing between the plurality of superconducting filaments 80, and does not include the second stabilizing matrix 51 not interposed between the plurality of superconducting filaments 80.

FIGS. 3 and 4 respectively show the Nb-based superconducting element wires 70 and 70a produced by an internal diffusion method. In the internal diffusion method, when the Nb₃Sn superconducting wire precursor 1 is subjected to a heat treatment for generating the compound superconducting phase 73 including Nb₃Sn, Sn diffused from the Sn-based filaments 42 reacts with Nb on the surface of the Nb-based superconducting filament precursors 53 to generate a Nb₃Sn filament which is the compound superconducting phase 73. Therefore, the Nb₃Sn superconducting wire 2 does not include the Sn-based filaments 42. The heat treatment of the Nb₃Sn superconducting wire precursor 1 is performed, for example, in an inert gas atmosphere such as argon or nitrogen.

FIGS. 3 and 4 show examples in which in the Nb-based superconducting element wires 70 and 70a, the Nb-based superconducting filament precursor 53 remaining without reacting with Sn is present in the central portion of the superconducting filament 80. However, depending on the amount of Sn contained in the Sn-based filaments 42, the diameter size of the Nb-based superconducting filament precursors 53, or the like, the Nb-based superconducting filament precursor 53 may not be present in the superconducting filament 80, that is, the superconducting filament 80 may be composed of the compound superconducting phase 73.

As described above, the Nb₃Sn superconducting wire 2 includes the plurality of Nb-based reinforcing filaments 52 in the Nb-based superconducting element wire 70, 70a, and thus has high mechanical strength against tensile stress along the axial direction. In addition, when compressive stress along the radial direction is applied to the Nb₃Sn superconducting wire precursor 1 during production of a stranded wire or a rolling process, the portion of the second stabilizing matrix 51 in which the Nb-based reinforcing filaments 52 are embedded is preferentially deformed. Therefore, damage to the superconducting filaments 80 of the Nb₃Sn superconducting wire 2 due to a stranding process or a rolling process of the Nb₃Sn superconducting wire precursor 1 is small, and thus, a decrease in the critical current density Jc can be suppressed. Since the superconducting filaments 80 are protected in this manner, the Nb₃Sn superconducting wire 2 can exhibit a high critical current density Jc even when the Nb₃Sn superconducting wire precursor 1 is subjected to a stranding process or a rolling process.

The Nb-based reinforcing filament 52 and the Nb-based superconducting filament precursor 53 are both Nb or a Nb-based alloy. Therefore, it is possible to avoid deterioration in workability due to adjacent members having different mechanical properties.

Similarly to the Nb₃Sn superconducting wire precursor 1, it is preferable that in the cross section perpendicular to the axial direction of the Nb₃Sn superconducting wire 2 shown in each of FIGS. 3 and 4, in each of the plurality of Nb-based superconducting element wires 70, 70a, the Nb-based reinforcing filament aggregate 52a in which the plurality of Nb-based reinforcing filaments 52 are aggregated is disposed in the center, and the superconducting filament aggregate 80a in which the plurality of superconducting filaments 80 are aggregated is disposed on the outer periphery. In this case, the annular superconducting filament aggregate 80a disposed over the entire outer periphery of the Nb-based superconducting element wire 70, 70a surrounds the Nb-based reinforcing filament aggregate 52a disposed in the center of the Nb-based superconducting element wire 70, 70a. With such a configuration, Sn diffused from the Sn-based filaments 42 of the Nb₃Sn superconducting wire precursor 1 preferentially reacts with the plurality of Nb-based superconducting filament precursors 53, so that the Nb₃Sn superconducting wire 2 includes a high-quality compound superconducting phase 73 of Nb₃Sn.

The Nb₃Sn superconducting wire 2 as described above has high superconducting properties, strength against tensile stress in the axial direction, and resistance to deformation of the superconducting filament due to compressive stress in the radial direction. Therefore, the Nb₃Sn superconducting wire 2 is suitably used as a superconducting wire constituting a high magnetic field superconducting magnet used in a large accelerator, a nuclear fusion reactor, an analyzer, and the like.

According to the first embodiment described above, in the Nb₃Sn superconducting wire precursor, the plurality of Nb-based superconducting element wire precursors, constituting the superconducting element group precursor housed inside the diffusion barrier layer, have a predetermined configuration, so that the Nb₃Sn superconducting wire obtained by heat-treating the Nb₃Sn superconducting wire precursor has high mechanical strength capable of suppressing a decrease in the critical current density Jc due to tensile stress in the axial direction and compressive stress in the radial direction, and capable of suppressing damage to the superconducting filament precursors due to a stranding or rolling process.

### (Second Embodiment)

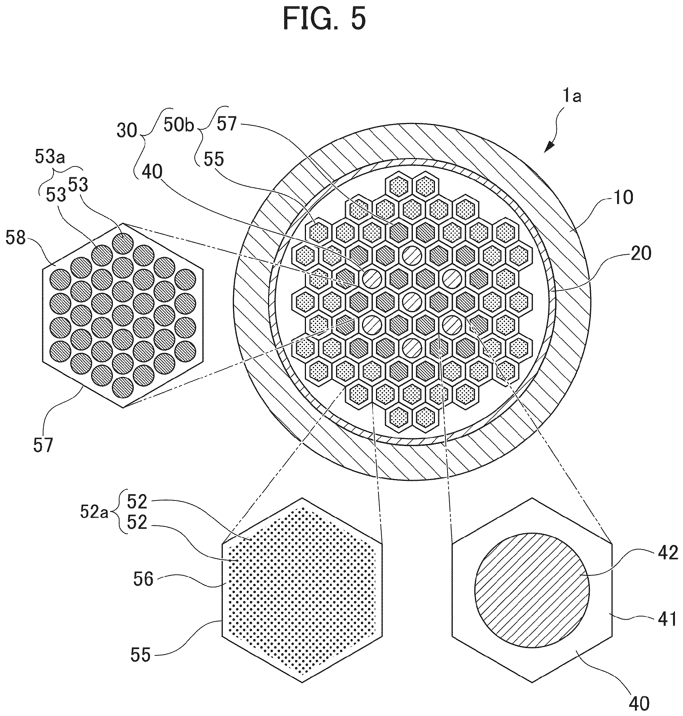

FIG. 5 is a transverse cross-sectional view showing an example of a Nb₃Sn superconducting wire precursor according to a second embodiment.

In the following embodiment, the same components as those of the Nb₃Sn superconducting wire precursor and the Nb₃Sn superconducting wire of the first embodiment are denoted by the same reference numerals, and redundant descriptions thereof will be omitted or simplified.

The configurations of a Nb₃Sn superconducting wire precursor 1a and a Nb₃Sn superconducting wire 2a in the second embodiment are basically the same as those of the Nb₃Sn superconducting wire precursor 1 and the Nb₃Sn superconducting wire 2 in the first embodiment except that a Nb-based superconducting element wire precursor 50b of the Nb₃Sn superconducting wire precursor 1a and a Nb-based superconducting element wire 70b of the Nb₃Sn superconducting wire 2a in the second embodiment have configurations different from those in the first embodiment. Therefore, the different configurations will be mainly described here.

As shown in FIG. 5, the Nb₃Sn superconducting wire precursor 1a according to the second embodiment includes a tubular stabilizing copper layer 10, a tubular first Sn diffusion barrier layer 20, and a superconducting element group precursor 30. The superconducting element group precursor 30 includes a plurality of Sn-based element wires 40 and a plurality of Nb-based superconducting element wire precursors 50b.

The plurality of Nb-based superconducting element wire precursors 50b include a plurality of Nb-based reinforcing sub-elements 55 and a plurality of Nb-based superconducting sub-element precursors 57.

Each of the plurality of Nb-based reinforcing sub-elements 55 includes a third stabilizing matrix 56 and a plurality of Nb-based reinforcing filaments 52. The third stabilizing matrix 56 includes Cu or a Cu-based alloy. The plurality of Nb-based reinforcing filaments 52 include Nb or an Nb-based alloy, and are embedded in the third stabilizing matrix 56.

Each of the plurality of Nb-based superconducting sub-element precursors 57 includes a fourth stabilizing matrix 58 and a plurality of Nb-based superconducting filament precursors 53. The fourth stabilizing matrix 58 includes Cu or a Cu-based alloy. The plurality of Nb-based superconducting filament precursors 53 include Nb or an Nb-based alloy, and are embedded in the fourth stabilizing matrix 58.

In the third stabilizing matrix 56 of the Nb-based reinforcing sub-element 55, the plurality of Nb-based reinforcing filaments 52 is provided, but the Nb-based superconducting filament precursor 53 is not provided. In the fourth stabilizing matrix 58 of the Nb-based superconducting sub-element precursor 57, the plurality of Nb-based superconducting filament precursors 53 is provided, but the Nb-based reinforcing filament 52 is not provided. That is, the Nb-based reinforcing filament 52 and the Nb-based superconducting filament precursor 53 are provided in different sub-elements (sub-element precursors).

Similarly to the Nb₃Sn superconducting wire precursor 1, in the Nb₃Sn superconducting wire precursor 1a, the diameter of the Nb-based superconducting filament precursor 53 embedded in the fourth stabilizing matrix 58 is larger than the diameter of the Nb-based reinforcing filament 52 embedded in the third stabilizing matrix 56. For example, the diameter of the Nb-based reinforcing filament 52 is 0.04 µm or more and 0.30 µm or less, and the diameter of the Nb-based superconducting filament precursor 53 is 1 µm or more and 10 µm or less.

In the cross section perpendicular to the axial direction of the Nb₃Sn superconducting wire precursor 1a, the ratio of the total area of the plurality of Nb-based reinforcing filaments 52 to the area of the Nb-based reinforcing filament aggregate 52a in which the plurality of Nb-based reinforcing filaments 52 are aggregated is smaller than the ratio of the total area of the plurality of Nb-based superconducting filament precursors 53 to the area of the Nb-based superconducting filament aggregate precursor 53a in which the plurality of Nb-based superconducting filament precursors 53 are aggregated. For example, the ratio of the total area of the plurality of Nb-based reinforcing filaments 52 to the area of the Nb-based reinforcing filament aggregate 52a is 0.1 or more and 0.5 or less, and the ratio of the total area of the plurality of Nb-based superconducting filament precursors 53 to the area of the Nb-based superconducting filament aggregate precursor 53a is 0.6 or more and 0.9 or less. Here, it is defined that the Nb-based reinforcing filament aggregate 52a of the Nb₃Sn superconducting wire precursor 1a includes the plurality of Nb-based reinforcing filaments 52, and the third stabilizing matrix 56 existing between the plurality of Nb-based reinforcing filaments 52, and does not include the third stabilizing matrix 56 not interposed between the plurality of Nb-based reinforcing filaments 52. Further, it is defined that the Nb-based superconducting filament aggregate precursor 53a of the Nb₃Sn superconducting wire precursor 1a includes the plurality of Nb-based superconducting filament precursors 53 and the fourth stabilizing matrix 58 existing between the plurality of Nb-based superconducting filament precursors 53, and does not include the fourth stabilizing matrix 58 not interposed between the plurality of Nb-based superconducting filament precursors 53.

By applying a heat treatment for generating the compound superconducting phase 73 described later, all or part of the Nb-based superconducting filament precursors 53 reacts with Sn diffused from the Sn-based filaments 42 to form a filament-shaped compound superconducting phase 73 including Nb₃Sn.

As described above, by providing the plurality of Nb-based reinforcing filaments 52 in the Nb-based superconducting element wire precursor 50b, the Nb₃Sn superconducting wire precursor 1a and the Nb₃Sn superconducting wire described later have high mechanical strength against tensile stress in the axial direction. When compressive stress along the radial direction is applied to the Nb₃Sn superconducting wire precursor 1 or the Nb₃Sn superconducting wire, the third stabilizing matrix 56 in which the Nb-based reinforcing filaments 52 are embedded, in other words, the third stabilizing matrix 56 of the Nb-based reinforcing filament aggregate 52a is preferentially deformed. Therefore, damage to the superconducting filaments during a stranding process or a rolling process is small, and a decrease in the critical current density Jc of the Nb₃Sn superconducting wire can be suppressed. As described above, since damage to the superconducting filament precursors due to a stranding process or a rolling process can be suppressed, the superconducting filaments are protected, and thus the Nb₃Sn superconducting wire can exhibit a high critical current density Jc even when subjected to stranding.

The Nb-based reinforcing filament 52 and the Nb-based superconducting filament precursor 53 are both Nb or a Nb-based alloy. Therefore, it is possible to avoid deterioration in workability due to adjacent members having different mechanical properties.

It is preferable that, in the cross section perpendicular to the axial direction of the Nb₃Sn superconducting wire precursor 1a, the plurality of Nb-based superconducting sub-element precursors 57 and the plurality of Sn-based element wires 40 are disposed in the center of the superconducting element group precursor 30, and the plurality of Nb-based reinforcing sub-elements 55 are disposed on the outer periphery of the superconducting element group precursor 30. In this case, the plurality of Nb-based reinforcing sub-elements 55 annularly disposed over the entire outer periphery of the superconducting element group precursor 30 surround the plurality of Nb-based superconducting sub-element precursors 57 and the plurality of Sn-based element wires 40 disposed in the center of the superconducting element group precursor 30. With such a configuration, Sn diffused from the Sn-based filaments 42 of the Sn-based element wires 40 preferentially reacts with the plurality of Nb-based superconducting filament precursors 53 when the Nb₃Sn superconducting wire precursor 1a is subjected to a heat treatment for generating the compound superconducting phase 73 including Nb₃Sn described later, so that a high-quality compound superconducting phase 73 of Nb₃Sn is easily formed.

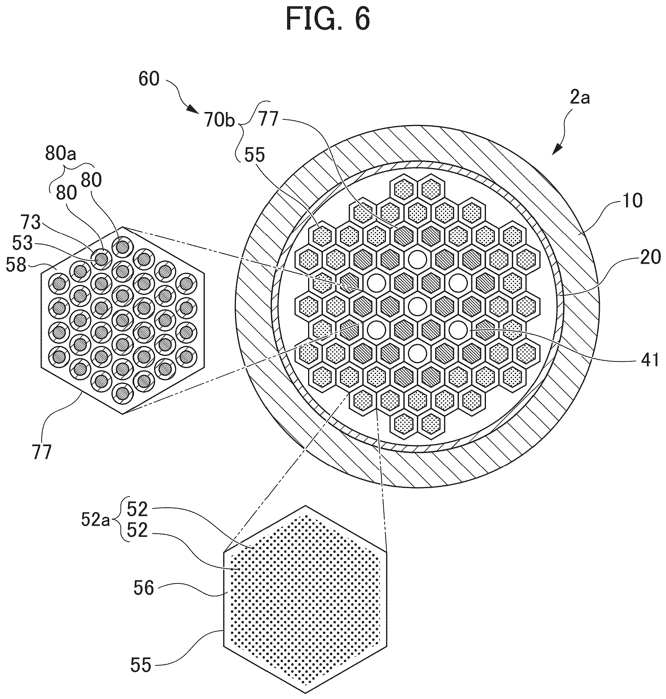

Next, the Nb₃Sn superconducting wire 2a obtained by subjecting the Nb₃Sn superconducting wire precursor 1a to a heat treatment for generating the compound superconducting phase 73 including Nb₃Sn will be described. FIG. 6 is a transverse cross-sectional view showing the Nb₃Sn superconducting wire 2a obtained by heating the Nb₃Sn superconducting wire precursor 1a of FIG. 5.

As shown in FIG. 6, the Nb₃Sn superconducting wire 2a, which is a heat-treated product of the Nb₃Sn superconducting wire precursor 1a, includes a tubular stabilizing copper layer 10, a tubular first Sn diffusion barrier layer 20, and a superconducting element group 60.

The superconducting element group 60 includes a plurality of Nb-based superconducting element wires 70b. The plurality of Nb-based superconducting element wires 70b include a plurality of Nb-based reinforcing sub-elements 55 and a plurality of superconducting sub-elements 77.

The Nb-based reinforcing sub-element 55 of the Nb₃Sn superconducting wire 2a has the same configuration as the Nb-based reinforcing sub-element 55 of the Nb₃Sn superconducting wire precursor 1a.

Each of the plurality of superconducting sub-elements 77 includes a fourth stabilizing matrix 58 and a plurality of superconducting filaments 80. The fourth stabilizing matrix 58 includes Cu or a Cu-based alloy. The plurality of superconducting filaments 80 are embedded in the fourth stabilizing matrix 58.

Each of the plurality of superconducting filaments 80 includes a compound superconducting phase 73 including Nb₃Sn. The diameter of the superconducting filament 80 is larger than the diameter of the Nb-based reinforcing filament 52 embedded in the third stabilizing matrix 56. For example, the diameter of the Nb-based reinforcing filament 52 is 0.04 µm or more and 0.30 µm or less, and the diameter of the superconducting filament 80 is 1 µm or more and 10 µm or less.

In the cross section perpendicular to the axial direction of the Nb₃Sn superconducting wire 2a, the ratio of the total area of the plurality of Nb-based reinforcing filaments 52 to the area of the Nb-based reinforcing filament aggregate 52a in which the plurality of Nb-based reinforcing filaments 52 are aggregated is smaller than the ratio of the total area of the plurality of superconducting filaments 80 to the area of the superconducting filament aggregate 80a in which the plurality of superconducting filaments 80 are aggregated. For example, the ratio of the total area of the plurality of Nb-based reinforcing filaments 52 to the area of the Nb-based reinforcing filament aggregate 52a is 0.1 or more and 0.5 or less, and the ratio of the total area of the plurality of superconducting filaments 80 to the area of the superconducting filament aggregate 80a is 0.6 or more and 0.9 or less. Here, it is defined that the superconducting filament aggregate 80a of the Nb₃Sn superconducting wire 2a includes the plurality of superconducting filaments 80 and the fourth stabilizing matrix 58 existing between the plurality of superconducting filaments 80, and does not include the fourth stabilizing matrix 58 not interposed between the plurality of superconducting filaments 80.

In the third stabilizing matrix 56 of the Nb-based reinforcing sub-element 55, the plurality of Nb-based reinforcing filaments 52 are provided, but the superconducting filaments 80 are not provided. In the fourth stabilizing matrix 58 of the superconducting sub-element 77, the plurality of superconducting filaments 80 are provided, but the Nb-based reinforcing filaments 52 are not provided. That is, the Nb-based reinforcing filaments 52 and the superconducting filaments 80 are provided in different sub-elements.

FIG. 6 shows the Nb-based superconducting element wire 70b produced by an internal diffusion method. In the internal diffusion method, when the Nb₃Sn superconducting wire precursor 1a is subjected to a heat treatment for generating a compound superconducting phase 73 including Nb₃Sn, Sn diffused from the Sn-based filaments 42 reacts from Nb on the surface of the Nb-based superconducting filament precursors 53 to generate a Nb₃Sn filament which is the compound superconducting phase 73. Therefore, the Nb₃Sn superconducting wire 2a does not include the Sn-based filaments 42. The heat treatment of the Nb₃Sn superconducting wire precursor 1a is performed, for example, in an inert gas atmosphere such as argon or nitrogen.

In the Nb-based superconducting element wire 70b shown in FIG. 6, an example is shown in which the Nb-based superconducting filament precursor 53 remaining without reacting with Sn is present in the central portion of the superconducting filament 80. However, depending on the amount of Sn contained in the Sn-based filaments 42, the diameter size of the Nb-based superconducting filament precursors 53, and the like, the Nb-based superconducting filament precursor 53 may not be present in the superconducting filament 80, that is, the superconducting filament 80 may be composed of the compound superconducting phase 73.

As described above, since the Nb-based superconducting element wire 70b includes the plurality of Nb-based reinforcing filaments 52, the Nb₃Sn superconducting wire 2a has high mechanical strength against tensile stress along the axial direction. In addition, when compressive stress along the radial direction is applied to the Nb₃Sn superconducting wire precursor 1a during production of a stranded wire or a rolling process, the third stabilizing matrix 56 in which the Nb-based reinforcing filaments 52 are embedded is preferentially deformed. Therefore, damage to the superconducting filaments 80 of the Nb₃Sn superconducting wire 2a due to a stranding process or a rolling process of the Nb₃Sn superconducting wire precursor 1a is small, and thus, a decrease in the critical current density Jc of the Nb₃Sn superconducting wire 2a can be suppressed. Since the superconducting filaments 80 are protected in this manner, the Nb₃Sn superconducting wire 2a can exhibit a high critical current density Jc even when the Nb₃Sn superconducting wire precursor 1a is subjected to a stranding process or a rolling process.

The Nb-based reinforcing filament 52 and the Nb-based superconducting filament precursor 53 are both Nb or a Nb-based alloy. Therefore, it is possible to avoid deterioration in workability due to adjacent members having different mechanical properties.

Similarly to the Nb₃Sn superconducting wire precursor 1a, it is preferable that in the cross section perpendicular to the axial direction of the Nb₃Sn superconducting wire 2a, the plurality of superconducting sub-elements 77 and the plurality of Sn-based element wires 40 are disposed in the center of the superconducting element group 60, and the plurality of Nb-based reinforcing sub-elements 55 are disposed on the outer periphery of the superconducting element group 60. In this case, the plurality of Nb-based reinforcing sub-elements 55 annularly disposed over the entire outer periphery of the superconducting element group 60 surround the plurality of superconducting sub-elements 77 and the plurality of Sn-based element wires 40 disposed in the center of the superconducting element group 60. With such a configuration, Sn diffused from the Sn-based filaments 42 preferentially reacts with the plurality of Nb-based superconducting filament precursors 53, so that the Nb₃Sn superconducting wire 2a includes a high-quality compound superconducting phase 73 of Nb₃Sn.

According to the second embodiment described above, even when the Nb-based reinforcing filaments 52 and the superconducting filaments 80 are provided in different sub-elements, the Nb₃Sn superconducting wire obtained by heat-treating the Nb₃Sn superconducting wire precursor can has high mechanical strength capable of suppressing a decrease in the critical current density Jc due to tensile stress along the axial direction and compressive stress along the radial direction, and capable of suppressing damage to the superconducting filament precursors due to a stranding process or a rolling process.

The first embodiment shows the Nb₃Sn superconducting wire precursor 1 including the Nb-based superconducting element wire precursors 50, 50a, and the second embodiment shows the Nb₃Sn superconducting wire precursor 1a including the Nb-based superconducting element wire precursors 50b. However, it is only required that the Nb₃Sn superconducting wire precursor includes at least one type of the Nb-based superconducting element wire precursor 50, the Nb-based superconducting element wire precursor 50a, or the Nb-based superconducting element wire precursor 50b. For example, the Nb₃Sn superconducting wire precursor may include two types of Nb-based superconducting element wire precursors, namely, the Nb-based superconducting element wire precursor 50 and the Nb-based superconducting element wire precursor 50a, or may include three types of Nb-based superconducting element wire precursors, namely, the Nb-based superconducting element wire precursor 50, the Nb-based superconducting element wire precursor 50a, and the Nb-based superconducting element wire precursor 50b.

The first embodiment shows the Nb₃Sn superconducting wire 2 including the Nb-based superconducting element wire 70, 70a, and the second embodiment shows the Nb₃Sn superconducting wire 2a including the Nb-based superconducting element wire 70b. However, it is only required that the Nb₃Sn superconducting wire includes at least one type of the Nb-based superconducting element wire 70, the Nb-based superconducting element wire 70a, or the Nb-based superconducting element wire 70b. For example, the Nb₃Sn superconducting wire may include two types of Nb-based superconducting element wires, namely, the Nb-based superconducting element wire 70 and the Nb-based superconducting element wire 70a, or may include three types of Nb-based superconducting element wires, namely, the Nb-based superconducting element wire 70, the Nb-based superconducting element wire 70a, and the Nb-based superconducting element wire 70b.

Although the embodiments have been described above, the present invention is not limited to the above embodiments, but includes all aspects included in the concept of the present disclosure and the claims, and can be modified in various ways within the scope of the present disclosure.

### EXAMPLES

Next, examples and comparative examples will be described, but the present disclosure is not limited to these examples.

### (Example 1)

A Nb₃Sn superconducting wire precursor including Nb-based superconducting element wire precursors 50 as shown in FIG. 1 and a Nb₃Sn superconducting wire including Nb-based superconducting element wires 70 as shown in FIG. 3 were produced.

First, a Sn-Ti rod (Sn-1.7 wt% Ti, diameter 24.5 mmφ) was inserted into a copper tube (oxygen-free copper, outer diameter 30.0 mmφ, inner diameter 24.5 mmφ), and the resultant sample was drawn a plurality of times to form a Sn-based element wire having a width across flats of 2.24 mmH.

Further, a Nb rod (pure Nb, diameter 24.3 mmφ) was inserted into a copper tube (oxygen-free copper, outer diameter 27.5 mmφ, inner diameter 24.5 mmφ), and the resultant sample was drawn a plurality of times to form a Nb-based superconducting filament hexagonal wire having a width across flats of 1.71 mmH.

Further, a Nb rod (pure Nb, diameter 103.0 mmφ) was inserted into a copper tube (oxygen-free copper, outer diameter 214.0 mmφ, inner diameter 103.7 mmφ), and the resultant sample was extruded, and then drawn and peeled a plurality of times to form a Nb-based reinforcing filament primary hexagonal wire having a width across flats of 13.4 mmH.

Next, 109 of the above Nb-based reinforcing filament primary hexagonal wires were inserted into a copper tube (oxygen-free copper, outer diameter 214.0 mmφ, inner diameter 166.0 mmφ), and the resultant sample was subjected to HIP (hot isostatic pressing) and external cutting and then extruded, and further drawn and peeled a plurality of times to form a Nb-based reinforcing filament secondary hexagonal wire having a width across flats of 1.71 mmH.

Next, 37 of the above Nb-based reinforcing filament secondary hexagonal wires and 114 of the above Nb-based superconducting filament hexagonal wires were inserted into a copper tube (oxygen-free copper, outer diameter 27.5 mmφ, inner diameter 24.5 mmφ) in such an arrangement that the aggregate of the Nb-based reinforcing filament secondary hexagonal wires was surrounded by the aggregate of the Nb-based superconducting filament hexagonal wires, and the resultant sample was subjected to HIP and external cutting and then extruded, and further drawn a plurality of times to form a Nb-based superconducting element wire having a width across flats of 2.24 mmH.

Next, 19 of the above Sn-based element wires and 36 of the above Nb-based superconducting element wires were inserted into a copper tube (oxygen-free copper, outer diameter 30.0 mmφ, inner diameter 20.0 mmφ) in such an arrangement that the Sn-based element wires were not adjacent to each other, and the resultant sample was subjected to CIP (cold isostatic pressing) and external cutting and then drawn a plurality of times to form a Nb₃Sn superconducting wire precursor having a diameter of 0.6 mmφ. In the Nb₃Sn superconducting wire precursor, the diameter of the Nb-based superconducting filament precursor was larger than the diameter of the Nb-based reinforcing filament.

Next, the obtained Nb₃Sn superconducting wire precursor was subjected to a heat treatment of heating at 210°C for 6 hours, subsequently heating at 350°C for 18 hours, subsequently heating at 480°C for 28 hours, subsequently heating at 570°C for 180 hours, and subsequently heating at 665°C for 200 hours in order to form a compound superconducting phase including Nb₃Sn, thereby obtaining a Nb₃Sn superconducting wire. In the Nb₃Sn superconducting wire, the diameter of the superconducting filament was larger than the diameter of the Nb-based reinforcing filament.

The obtained Nb₃Sn superconducting wire had high mechanical strength capable of suppressing a decrease in the critical current density Jc due to tensile stress in the axial direction and compressive stress in the radial direction, and further capable of suppressing damage to the superconducting filament precursors due to a stranding process or a rolling process.

### (Example 2)

A Nb₃Sn superconducting wire precursor including Nb-based superconducting element wire precursors 50a as shown in FIG. 2 and a Nb₃Sn superconducting wire including Nb-based superconducting element wires 70a as shown in FIG. 4 were produced.

First, a Sn-Ti rod (Sn-1.7 wt% Ti, diameter 24.5 mmφ) was inserted into a copper tube (oxygen-free copper, outer diameter 30.0 mmφ, inner diameter 24.5 mmφ) and the resultant sample was drawn a plurality of times to form a Sn-based element wire having a width across flats of 2.24 mmH.

Further, a Nb rod (pure Nb, diameter 24.3 mmφ) was inserted into a copper tube (oxygen-free copper, outer diameter 27.5 mmφ, inner diameter 24.5 mmφ) and the resultant sample was drawn a plurality of times to form a Nb-based superconducting filament hexagonal wire having a width across flats of 1.71 mmH.

Further, a Nb rod (pure Nb, diameter 103.0 mmφ) was inserted into a copper tube (oxygen-free copper, outer diameter 214.0 mmφ, inner diameter 103.7 mmφ), and the resultant sample was extruded, and then drawn and peeled a plurality of times to form a Nb-based reinforcing filament primary hexagonal wire having a width across flats of 13.4 mmH.

Next, 109 of the above Nb-based reinforcing filament primary hexagonal wires were inserted into a copper tube (oxygen-free copper, outer diameter 214.0 mmφ, inner diameter 166.0 mmφ), and the resultant sample was subjected to HIP and external cutting and then extruded, and further drawn and peeled a plurality of times to form a Nb-based reinforcing filament secondary hexagonal wire having a width across flats of 1.71 mmH.

Next, a wire aggregate in which 19 of the above Nb-based reinforcing filament secondary hexagonal wires were wrapped twice with Nb foil having a thickness of 0.1 mm, and further 114 of the above Nb-based superconducting filament hexagonal wires were disposed around the Nb foil, was inserted into a copper tube (oxygen-free copper, outer diameter 27.5 mmφ, inner diameter 24.5 mmφ), and the resultant sample was subjected to HIP and external cutting and then extruded, and further drawn a plurality of times to form a Nb-based superconducting element wire having a width across flats of 2.24 mmH.

Next, 19 of the above Sn-based element wires and 36 of the above Nb-based superconducting element wires were inserted into a copper tube (oxygen-free copper, outer diameter 30.0 mmφ, inner diameter 20.0 mmφ) in such an arrangement that the Sn-based element wires were not adjacent to each other, and the resultant sample was subjected to CIP and external cutting and then drawn a plurality of times to form a Nb₃Sn superconducting wire precursor having a diameter of 0.6 mmφ. In the Nb₃Sn superconducting wire precursor, the diameter of the Nb-based superconducting filament precursor was larger than the diameter of the Nb-based reinforcing filament.

Next, the obtained Nb₃Sn superconducting wire precursor was subjected to a heat treatment of heating at 210°C for 6 hours, subsequently heating at 350°C for 18 hours, subsequently heating at 480°C for 28 hours, subsequently heating at 570°C for 180 hours, and subsequently heating at 665°C for 200 hours in order to form a compound superconducting phase including Nb₃Sn, thereby obtaining a Nb₃Sn superconducting wire. In the Nb₃Sn superconducting wire, the diameter of the superconducting filament was larger than the diameter of the Nb-based reinforcing filament.

The obtained Nb₃Sn superconducting wire had high mechanical strength capable of suppressing a decrease in the critical current density Jc due to tensile stress in the axial direction and compressive stress in the radial direction, and further capable of suppressing damage to the superconducting filament precursors due to a stranding process or a rolling process.

### (Example 3)

A Nb₃Sn superconducting wire precursor including Nb-based superconducting element wire precursors 50b as shown in FIG. 5 and a Nb₃Sn superconducting wire including Nb-based superconducting element wires 70b as shown in FIG. 6 were produced.

First, a Sn-Ti rod (Sn-1.7 wt% Ti, diameter 24.5 mmφ) was inserted into a copper tube (oxygen-free copper, outer diameter 30.0 mmφ, inner diameter 24.5 mmφ) and the resultant sample was drawn a plurality of times to form a Sn-based element wire having a width across flats of 2.24 mmH.

Further, an Nb rod (pure Nb, diameter 24.3 mmφ) was inserted into a copper tube (oxygen-free copper, outer diameter 27.5 mmφ, inner diameter 24.5 mmφ) and the resultant sample was drawn a plurality of times to form a Nb-based superconducting filament hexagonal wire having a width across flats of 1.71 mmH. Next, 151 of the above Nb-based superconducting filament hexagonal wires were inserted into a copper tube (oxygen-free copper, outer diameter 27.5 mmφ, inner diameter 24.5 mmφ), and the resultant sample was subjected to HIP and external cutting and then extruded, and further drawn a plurality of times to form a Nb-based superconducting sub-element wire having a width across flats of 2.24 mmH.

Further, a Nb rod (pure Nb, diameter 103.0 mmφ) was inserted into a copper tube (oxygen-free copper, outer diameter 214.0 mmφ, inner diameter 103.7 mmφ), and the resultant sample was extruded, and then drawn and peeled a plurality of times to form a Nb-based reinforcing filament primary hexagonal wire having a width across flats of 13.4 mmH. Next, 109 of the above Nb-based reinforcing filament primary hexagonal wires were inserted into a copper tube (oxygen-free copper, outer diameter 214.0 mmφ, inner diameter 166.0 mmφ), and the resultant sample was subjected to HIP and external cutting and then extruded, and further drawn and peeled a plurality of times to form a Nb-based reinforcing filament secondary hexagonal wire having a width across flats of 1.71 mmH. Next, 151 of the above Nb-based reinforcing filament secondary hexagonal wires were inserted into a copper tube (oxygen-free copper, outer diameter 27.5 mmφ, inner diameter 24.5 mmφ), the resultant sample was subjected to HIP and external cutting and then extruded, and further drawn a plurality of times to form a Nb-based reinforcing sub-element wire having a width across flats of 2.24 mmH.

Next, seven of the above Sn-based element wires, 30 of the above Nb-based superconducting sub-element wires, and 18 of the above Nb-based reinforcing sub-element wires were inserted into a copper tube (oxygen-free copper, outer diameter 30.0 mmφ, inner diameter 20.0 mmφ) in such an arrangement that the Sn-based element wires were not adjacent to each other and the Nb-based reinforcing sub-element wires were positioned on the outer periphery of the element wire aggregate, the resultant sample was subjected to CIP and outer cutting and then drawn a plurality of times to form a Nb₃Sn superconducting wire precursor having a diameter of 0.6 mmφ. In the Nb₃Sn superconducting wire precursor, the diameter of the Nb-based superconducting filament precursor was larger than the diameter of the Nb-based reinforcing filament.

Next, the obtained Nb₃Sn superconducting wire precursor was subjected to a heat treatment of heating at 210°C for 6 hours, subsequently heating at 350°C for 18 hours, subsequently heating at 480°C for 28 hours, subsequently heating at 570°C for 180 hours, and subsequently heating at 665°C for 200 hours in order to form a compound superconducting phase including Nb₃Sn, thereby obtaining a Nb₃Sn superconducting wire. In the Nb₃Sn superconducting wire, the diameter of the superconducting filament was larger than the diameter of the Nb-based reinforcing filament.

The obtained Nb₃Sn superconducting wire had high mechanical strength capable of suppressing a decrease in the critical current density Jc due to tensile stress in the axial direction and compressive stress in the radial direction, and further capable of suppressing damage to the superconducting filament precursors due to a stranding process or a rolling process.

### EXPLANATION OF REFERENCE NUMERALS

1, 1a Nb₃Sn superconducting wire precursor
2, 2a Nb₃Sn superconducting wire
10 stabilizing copper layer
20 first Sn diffusion barrier layer
30 superconducting element group precursor
40 Sn-based element wire
41 first stabilizing matrix
42 Sn-based filament
50, 50a, 50b Nb-based superconducting element wire precursor
51 second stabilizing matrix
52 Nb-based reinforcing filament
52a Nb-based reinforcing filament aggregate
53 Nb-based superconducting filament precursor
53a Nb-based superconducting filament aggregate precursor
54 second Sn diffusion barrier layer
55 Nb-based reinforcing sub-element
56 third stabilizing matrix
57 Nb-based superconducting sub-element precursor
58 fourth stabilizing matrix
60 superconducting element group
70, 70a, 70b Nb-based superconducting element wire
73 compound superconducting phase
77 superconducting sub-element
80 superconducting filament
80a superconducting filament aggregate

## Claims

1. A Nb₃Sn superconducting wire precursor comprising:
a tubular stabilizing copper layer provided on an outer periphery;
a tubular first Sn diffusion barrier layer provided inside the stabilizing copper layer; and
a superconducting element group precursor housed inside the first Sn diffusion barrier layer,
the superconducting element group precursor comprising a plurality of Sn-based element wires and a plurality of Nb-based superconducting element wire precursors,
the plurality of Sn-based element wires comprising a first stabilizing matrix including Cu or a Cu-based alloy, and one or more Sn-based filaments embedded in the first stabilizing matrix and including Sn or a Sn-based alloy,
the plurality of Nb-based superconducting element wire precursors comprising
a second stabilizing matrix including Cu or a Cu-based alloy, a plurality of Nb-based reinforcing filaments embedded in the second stabilizing matrix and including Nb or a Nb-based alloy, and a plurality of Nb-based superconducting filament precursors having a diameter larger than that of the Nb-based reinforcing filaments, embedded in the second stabilizing matrix, and including Nb or a Nb-based alloy, and/or
a plurality of Nb-based reinforcing sub-elements comprising a third stabilizing matrix including Cu or a Cu-based alloy, and a plurality of Nb-based reinforcing filaments embedded in the third stabilizing matrix and including Nb or a Nb-based alloy; and a plurality of Nb-based superconducting sub-element precursors comprising a fourth stabilizing matrix including Cu or a Cu-based alloy, and a plurality of Nb-based superconducting filament precursors embedded in the fourth stabilizing matrix, including Nb or a Nb-based alloy, and having a diameter larger than that of the Nb-based reinforcing filaments.

2. The Nb₃Sn superconducting wire precursor according to claim 1, wherein in a cross section perpendicular to an axial direction of the Nb₃Sn superconducting wire precursor, in each of the plurality of Nb-based superconducting element wire precursors, a Nb-based reinforcing filament aggregate in which the plurality of Nb-based reinforcing filaments are aggregated is disposed in a center, and a Nb-based superconducting filament aggregate precursor in which the plurality of Nb-based superconducting filament precursors are aggregated is disposed on an outer periphery.

3. The Nb₃Sn superconducting wire precursor according to claim 2, wherein the Nb-based superconducting element wire precursors further comprise a second Sn diffusion barrier layer provided between the Nb-based reinforcing filament aggregate and the Nb-based superconducting filament aggregate precursor in the cross section perpendicular to the axial direction of the Nb₃Sn superconducting wire precursor, the second Sn diffusion barrier layer including a pure metal or alloy each containing Ta or Nb.

4. The Nb₃Sn superconducting wire precursor according to claim 1, wherein in a cross section perpendicular to an axial direction of the Nb₃Sn superconducting wire precursor, the plurality of Nb-based superconducting sub-element precursors and the plurality of Sn-based element wires are disposed in a center of the superconducting element group precursor, and the plurality of Nb-based reinforcing sub-elements are disposed on an outer periphery of the superconducting element group precursor.

5. The Nb₃Sn superconducting wire precursor according to claim 1, wherein the first Sn diffusion barrier layer comprises a pure metal or alloy each containing Ta or Nb.

6. A Nb₃Sn superconducting wire comprising:
a tubular stabilizing copper layer provided on an outer periphery;
a tubular first Sn diffusion barrier layer provided inside the stabilizing copper layer; and
a superconducting element group housed inside the first Sn diffusion barrier layer,
the superconducting element group comprising a plurality of Nb-based superconducting element wires,
the plurality of Nb-based superconducting element wires comprising
a second stabilizing matrix including Cu or a Cu-based alloy and a plurality of superconducting filaments embedded in the second stabilizing matrix, the plurality of superconducting filaments comprising a plurality of Nb-based reinforcing filaments including Nb or a Nb-based alloy and a compound superconducting phase including Nb₃Sn, and the plurality of superconducting filaments having a diameter larger than that of the Nb-based reinforcing filaments, and/or
a plurality of Nb-based reinforcing sub-elements comprising a third stabilizing matrix including Cu or a Cu-based alloy, and a plurality of Nb-based reinforcing filaments embedded in the third stabilizing matrix and including Nb or a Nb-based alloy; and a plurality of superconducting sub-elements comprising a fourth stabilizing matrix including Cu or a Cu-based alloy, and a plurality of superconducting filaments embedded in the fourth stabilizing matrix, the plurality of superconducting filaments comprising a compound superconducting phase including Nb₃SN, and the plurality of superconducting filaments having a diameter larger than that of the Nb-based reinforcing filaments.

7. The Nb₃Sn superconducting wire according to claim 6, wherein the first Sn diffusion barrier layer comprises a pure metal or alloy each containing Ta or Nb.
